# EUROPEAN PATENT APPLICATION

(11) **EP 4 701 365 A1**
(43) Date of publication of application: **25.02.2026**
(21) Application number: 25167706.8
(22) Date of filing: 01.04.2025
(51) Int. Cl.: H10D 62/10, H10D 30/01, H10D 30/00, H10D 30/67, H10D 64/01, H10D 64/23, H10D 64/62

(54) **SEMICONDUCTOR DEVICE**

(30) Priority: 23.08.2024 KR 20240113516
(71) Applicant: Samsung Electronics Co., Ltd., Suwon-si, Gyeonggi-do 16677 (KR)
(72) Inventor: KANG, Hyun Woo, 16677 Suwon-si (KR); KIM, Wan Don, 16677 Suwon-si (KR); KANG, Ji Won, 16677 Suwon-si (KR); YOON, Sun No, 16677 Suwon-si (KR); HAN, Won Kyu, 16677 Suwon-si (KR)
(74) Representative: Marks & Clerk LLP

(57) **Abstract**

A semiconductor device may include an insulating pattern on a first lower interlayer insulating layer, nanosheets vertically stacked on the insulating pattern, a gate electrode on the insulating pattern and surrounding the nanosheets, a source/drain region on one side of the gate electrode on the insulating pattern, and a source/drain contact electrically connected to the source/drain region. The source/drain region, the first lower interlayer insulating layer, and the insulating pattern may define a contact trench and the source/drain contact may fill the contact trench. The source/drain contact may include a barrier layer, a first filling layer between parts of the barrier layer in the contact trench, and a second filling layer in the contact trench under the first filling layer. The first filling layer may be multi grain and may have a first average grain size. The second filling layer may be single grain.

## Description

### BACKGROUND

### 1. Technical Field

Various example embodiments relate to a semiconductor device. Specifically, the present disclosure relates to a semiconductor device including a MBCFET^{™} (Multi-Bridge Channel Field Effect Transistor).

### 2. Description of the Related Art

As one of the scaling techniques to increase the density of integrated circuit devices, multi-gate transistors have been proposed, in which a fin-shaped or a nanowire-shaped silicon body is formed on a substrate, and gates are formed on the surface of the silicon body.

Since these multi-gate transistors utilize a three-dimensional channel, they may be easier to scale. Additionally, the current control capability may be improved without increasing the gate length of the multi-gate transistor. Furthermore, the SCE(short channel effect), in which the potential of the channel region is influenced by the drain voltage, may be more effectively suppressed.

### SUMMARY

The present disclosure may provide a semiconductor device with reduced defects and/or resistance in the source/drain contact disposed beneath the source/drain region.

The aspects of the present disclosure are not limited to those mentioned above and other aspects may be clearly understood by those skilled in the art from the description below.

According to an embodiment of the present disclosure, a semiconductor device includes a first lower interlayer insulating layer; an insulating pattern extending in a first horizontal direction on an upper surface of the first lower interlayer insulating layer; a plurality of nanosheets stacked and spaced apart from each other in a vertical direction on the insulating pattern; a gate electrode extending in a second horizontal direction on the insulating pattern, the gate electrode surrounding the plurality of nanosheets, the second horizontal direction being different from the first horizontal direction; a source/drain region on one side of the gate electrode and on the insulating pattern; and a source/drain contact. The source/drain region, the first lower interlayer insulating layer, and the insulating pattern define a contact trench penetrating the first lower interlayer insulating layer and the insulating pattern in the vertical direction, the contact trench extending into an inside of the source/drain region. The source/drain contact fill an inside of the contact trench. The source/drain contact electrically connected to the source/drain region. The source/drain contact includes a barrier layer along a portion of an upper sidewall and an upper surface of the contact trench, a first filling layer filling a space between parts of the barrier layer inside the contact trench, and a second filling layer filling the inside of the contact trench under a bottom surface of the first filling layer. A sidewall in the first horizontal direction of the barrier layer is in contact with the insulating pattern. The first filling layer is multi grain and has a first average grain size in the first horizontal direction. A sidewall in the first horizontal direction of the second filling layer is in contact with each of the first lower interlayer insulating layer and the insulating pattern. The second filling layer is single grain.

According to an embodiment of the present disclosure, a semiconductor device includes a first lower interlayer insulating layer; an insulating pattern extending in a first horizontal direction on an upper surface of the first lower interlayer insulating layer; a gate electrode extending in a second horizontal direction different from the first horizontal direction on the insulating pattern; a source/drain region on one side of the gate electrode and on the insulating pattern, the source/drain region, the first lower interlayer insulating layer, and the insulating pattern defining a contact trench penetrating the first lower interlayer insulating layer and the insulating pattern in a vertical direction, the contact trench extending into an inside of the source/drain region; a source/drain contact filling an inside of the contact trench, the source/drain contact being electrically connected to the source/drain region; a second lower interlayer insulating layer on a bottom surface of the first lower interlayer insulating layer; and a bottom via in a via trench defined in the second lower interlayer insulating layer, the bottom via being in contact with a bottom surface of the source/drain contact, the bottom via is multi grain. The source/drain contact includes a barrier layer along a portion of an upper sidewall and an upper surface of the contact trench, a first filling layer filling a space between parts of the barrier layer inside the contact trench, and a second filling layer filling the inside of the contact trench under a bottom surface of the first filling layer. A sidewall in the first horizontal direction of the barrier layer is in contact with the insulating pattern. The first filling layer is multi grain and has a first average grain size in the first horizontal direction. A bottom surface of the second filling layer is in contact with the bottom via. A sidewall in the first horizontal direction of the second filling layer is in contact with each of the first lower interlayer insulating layer and the insulating pattern. The second filling layer is single grain. A second average grain size of the bottom via in the first horizontal direction is at least 1.5 times greater than the first average grain size.

According to an embodiment of the present disclosure, a semiconductor device may include a first lower interlayer insulating layer; an insulating pattern extending in a first horizontal direction on an upper surface of the first lower interlayer insulating layer; a plurality of nanosheets stacked and spaced apart from each other in a vertical direction on the insulating pattern; a gate electrode extending in a second horizontal direction on the insulating pattern, the second horizontal direction being different from the first horizontal direction, the gate electrode surrounding the plurality of nanosheets; a source/drain region on one side of the gate electrode and on the insulating pattern, where the source/drain region, the first lower interlayer insulating layer, and the insulating pattern define a contact trench penetrating the first lower interlayer insulating layer and the insulating pattern in a vertical direction, the contact trench extending into an inside of the source/drain region; a source/drain contact filling an inside of the contact trench, the source/drain contact electrically connected to the source/drain region; a second lower interlayer insulating layer disposed on a bottom surface of the first lower interlayer insulating layer; and a bottom via in a via trench defined in the second lower interlayer insulating layer, the bottom via being in contact with a bottom surface of the source/drain contact, the bottom via being multi grain. The source/drain contact may include a barrier layer along a portion of an upper sidewall and an upper surface of the contact trench, a first filling layer filling a space between parts of the barrier layer inside the contact trench, and a second filling layer filling the inside of the contact trench under a bottom surface of the first filling layer. A sidewall in the first horizontal direction of the barrier layer may be in contact with the insulating pattern. The first filling layer may be in contact with a lowermost surface of the barrier layer. The first filling layer may be multi grain may have has a first average grain size in the first horizontal direction. A bottom surface of the second filling layer may be in contact with the bottom via. A lowermost surface of the second filling layer may be lower than the bottom surface of the first lower interlayer insulating layer. A sidewall in the first horizontal direction of the second filling layer is in contact with each of the first lower interlayer insulating layer and the insulating pattern. The second filling layer may be single grain. A second average grain size of the bottom via in the first horizontal direction may be at least 1.5 times greater than the first average grain size.

At least some of the above and other features of the invention are set out in the claims.

### BRIEF DESCRIPTION OF THE DRAWINGS

The above and other aspects and features of the present disclosure will become more apparent by describing in detail embodiments thereof with reference to the attached drawings, in which:
FIG. 1 is a layout diagram for explaining a semiconductor device according to some example embodiments of the present disclosure;
FIG. 2 is a cross-sectional view taken along the line A-A' of FIG. 1;
FIG. 3 is an enlarged view of each of the region R1 and the region R2 of FIG. 2;
FIG. 4 is a cross-sectional view taken along the line B-B' of FIG. 1;
FIG. 5 is a cross-sectional view taken along the line C-C' of FIG. 1;
FIGS. 6 to 33 are intermediate stage diagrams for explaining the fabrication method of a semiconductor device according to some example embodiments of the present disclosure;
FIG. 34 is a cross-sectional view for explaining a semiconductor device according to some example embodiments of the present disclosure;
FIG. 35 is a cross-sectional view for explaining a semiconductor device according to some other example embodiments of the present disclosure;
FIG. 36 is a cross-sectional view for explaining a semiconductor device according to some other example embodiments of the present disclosure;
FIGS. 37 and 38 are cross-sectional views for explaining a semiconductor device according to some other example embodiments of the present disclosure;
FIGS. 39 and 40 are cross-sectional views for explaining a semiconductor device according to some other example embodiments of the present disclosure; and
FIGS. 41 and 42 are cross-sectional views for explaining a semiconductor device according to yet some other example embodiments of the present disclosure.

### DETAILED DESCRIPTION

In the following diagrams of a semiconductor device according to some example embodiments, the semiconductor device is described as including, by way of example, a transistor (MBCFET^{™} (Multi-Bridge Channel Field Effect Transistor)) that includes nanosheets, but the present disclosure is not limited thereto. In some other example embodiments, the semiconductor device may include a fin-shaped transistor (FinFET) having a channel region in a fin- shaped pattern, a tunneling transistor (tunneling FET), or a three-dimensional (3D) transistor. In addition, the semiconductor device according to some other example embodiments may include a bipolar junction transistor or a lateral double-diffused metal-oxide-semiconductor (LDMOS) transistor.

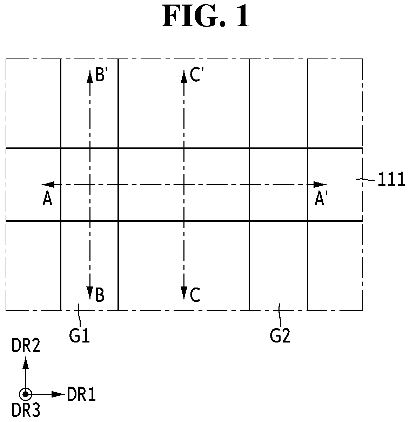

Hereinafter, a semiconductor device according to some example embodiments of the present disclosure will be described with reference to FIGS. 1 to 5.

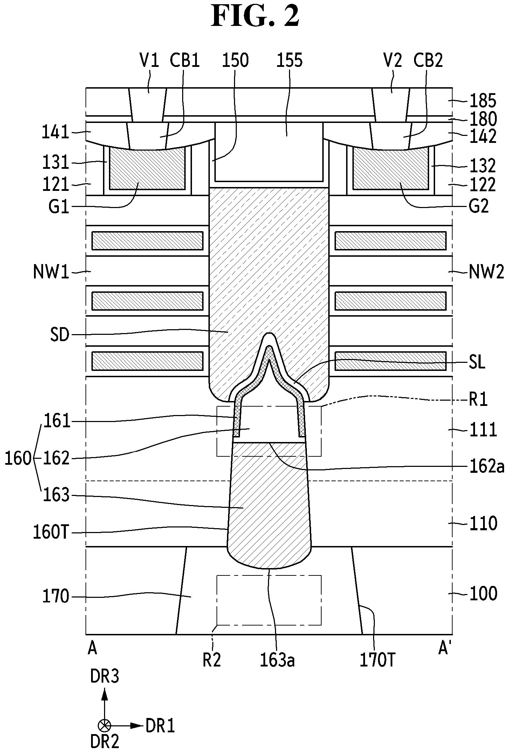

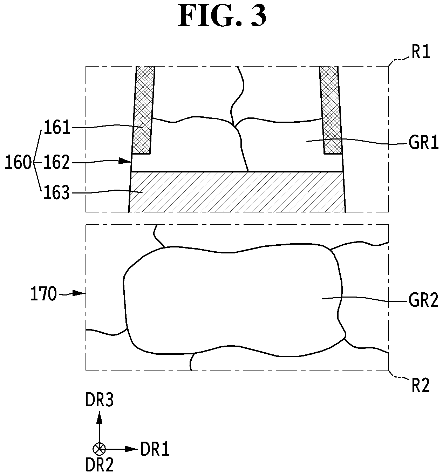

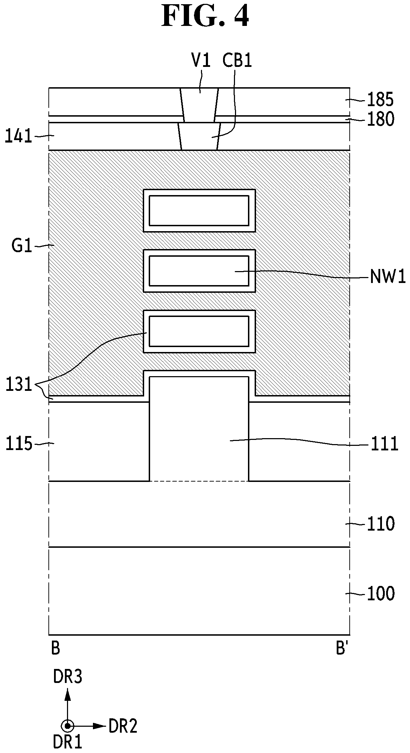

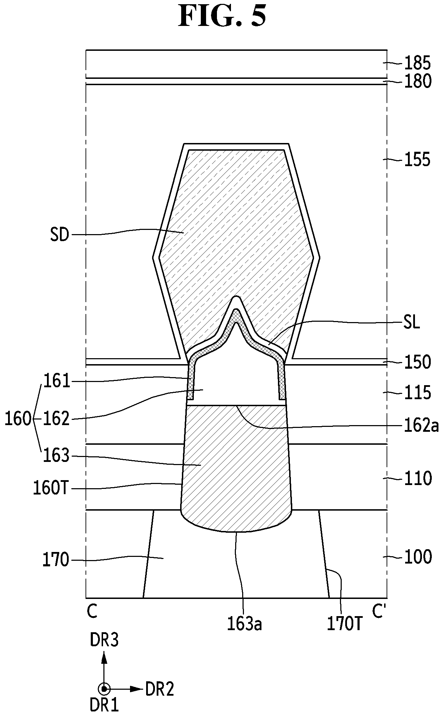

FIG. 1 is a layout diagram for explaining a semiconductor device according to some example embodiments of the present disclosure. FIG. 2 is a cross-sectional view taken along the line A-A' of FIG. 1. FIG. 3 is an enlarged view of each of the region R1 and the region R2 of FIG. 2. FIG. 4 is a cross-sectional view taken along the line B-B' of FIG. 1. FIG. 5 is a cross-sectional view taken along the line C-C' of FIG. 1.

Referring to FIGS. 1 to 5, a semiconductor device according to some example embodiments of the present disclosure includes a first lower interlayer insulating layer 110, a second lower interlayer insulating layer 100, an insulating pattern 111, a field insulating layer 115, first and second plurality of nanosheets NW1, NW2, first and second gate electrodes G1, G2, first and second gate spacers 121, 122, first and second gate insulating layer 131, 132, first and second capping patterns 141, 142, a source/drain region SD, a first etching stop layer 150, a first upper interlayer insulating layer 155, a source/drain contact 160, a silicide layer SL, a bottom via 170, first and second gate contacts CB1, CB2, a second etching stop layer 180, a second upper interlayer insulating layer 185, and first and second upper vias V1, V2. The source/drain region SD also may be referred to as a source/drain structure SD.

The first lower interlayer insulating layer 110 may include, for example, at least one of silicon oxide, silicon nitride, silicon oxynitride, and a low-k dielectric material. The low-k dielectric material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethylCycloTetraSiloxane (OMCTS), HexaMethylDiSiloxane (EA4DS), TriMethylSilyl Borate (TMSB), DiAcetoxyDitertiaryButoxySiloxane (DADBS), TriMethylSilil Phosphate (TMSP), PolyTetraFluoroEthylene (PTFE), TOSZ(Tonen SilaZen), FSG (Fluoride Silicate Glass), polyimide nanofoams such as polypropylene oxide, CDO(Carbon Doped silicon Oxide), OSG (Organo Silicate Glass), SiLK, Amorphous Fluorinated Carbon, silica aerogels, silica xerogels, mesoporous silica, or combinations thereof, but the present disclosure is not limited thereto.

Hereinafter, each of the first horizontal direction DR1 and the second horizontal direction DR2 may be defined as a direction parallel to the upper surface of the first lower interlayer insulating layer 110. The second horizontal direction DR2 is a direction different from the first horizontal direction DR1. The vertical direction DR3 may be defined as a direction perpendicular to each of the first horizontal direction DR1 and the second horizontal direction DR2. In other words, the vertical direction DR3 may be defined as a direction perpendicular to the upper surface of the first lower interlayer insulating layer 110.

The second lower interlayer insulating layer 100 may be disposed on a bottom surface of the first lower interlayer insulating layer 110. For example, the second lower interlayer insulating layer 100 may include at least one of silicon oxide, silicon nitride, silicon oxynitride, and a low-k dielectric material. In some example embodiments, the second lower interlayer insulating layer 100 may include a different material from the first lower interlayer insulating layer 110. However, the present disclosure is not limited thereto. In some other example embodiments, the second lower interlayer insulating layer 100 may include the same material as the first lower interlayer insulating layer 110.

The insulating pattern 111 extends in the first horizontal direction DR1 on the upper surface of the first lower interlayer insulating layer 110. The insulating pattern 111 may protrude in the vertical direction DR3 from the upper surface of the first lower interlayer insulating layer 110. The insulating pattern 111 may include an insulating material. For example, the insulating pattern 111 may include the same material as the first lower interlayer insulating layer 110. The field insulating layer 115 may be disposed on the upper surface of the first lower interlayer insulating layer 110. The field insulating layer 115 may surround the sidewalls of the insulating pattern 111. For example, the upper surface of the field insulating layer 115 may be formed lower than the upper surface of the insulating pattern 111. For example, the field insulating layer 115 may include an oxide layer, a nitride layer, an oxynitride layer, or a combination thereof.

Each of the first and second plurality of nanosheets NW1, NW2 may be disposed on the upper surface of the insulating pattern 111. The second plurality of nanosheets NW2 may be spaced apart from the first plurality of nanosheets NW1 in the first horizontal direction DR1. For example, each of the first and second plurality of nanosheets NW1, NW2 may include a plurality of nanosheets stacked and spaced apart from each other in the vertical direction DR3. In FIGS. 2 and 4, each of the first and second plurality of nanosheets NW1, NW2 is shown as including three nanosheets stacked and spaced apart from each other in the vertical direction DR3, but the present disclosure is not limited thereto. In some other example embodiments, each of the first and second plurality of nanosheets NW1, NW2 may include four or more nanosheets stacked and spaced apart from each other in the vertical direction DR3. For example, each of the first and second plurality of nanosheets NW1, NW2 may include silicon (Si).

Each of the first and second gate electrodes G1, G2 may extend in the second horizontal direction DR2 on the insulating pattern 111 and field insulating layer 115. The second gate electrode G2 may be spaced apart from the first gate electrode G1 in the first horizontal direction DR1. The first gate electrode G1 may surround the first plurality of nanosheets NW1. The second gate electrode G2 may surround the second plurality of nanosheets NW2.

Each of the first and second gate electrodes G1, G2 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof. Each of the first and second gate electrodes G1, G2 may include a conductive metal oxide, a conductive metal oxynitride, etc., and may also include the oxidized form of the aforementioned materials.

The first gate spacer 121 may extend in the second horizontal direction DR2 along both sidewalls of the first gate electrode G1 on the upper surface of the uppermost nanosheet of the first plurality of nanosheets NW1 and the field insulating layer 115. The second gate spacer 122 may extend in the second horizontal direction DR2 along both sidewalls of the second gate electrode G2 on the upper surface of the uppermost nanosheet of the second plurality of nanosheets NW2 and the field insulating layer 115. Each of the first and second gate spacers 121, 122 may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and combinations thereof. However, the present disclosure is not limited thereto.

For example, the source/drain region SD may be disposed between the first gate electrode G1 and the second gate electrode G2 on the upper surface of the insulating pattern 111. For example, the source/drain region SD may be in contact with the upper surface of the insulating pattern 111. For example, the source/drain region SD may be in contact with the sidewall of the first plurality of nanosheets NW1 in the first horizontal direction DR1 and the sidewall of the second plurality of nanosheets NW2 in the first horizontal direction DR1, respectively. For example, the upper surface of the source/drain region SD may be formed higher than the upper surface of the uppermost nanosheets of each of the first and second plurality of nanosheets NW1, NW2.

The first gate insulating layer 131 may be disposed between the first gate electrode G1 and the insulating pattern 111. The first gate insulating layer 131 may be disposed between the first gate electrode G1 and the field insulating layer 115. The first gate insulating layer 131 may be disposed between the first gate electrode G1 and the first gate spacer 121. The first gate insulating layer 131 may be disposed between the first gate electrode G1 and the first plurality of nanosheets NW1. The first gate insulating layer 131 may be disposed between the first gate electrode G1 and the source/drain region SD. The second gate insulating layer 132 may be disposed between the second gate electrode G2 and the insulating pattern 111. The second gate insulating layer 132 may be disposed between the second gate electrode G2 and the field insulating layer 115. The second gate insulating layer 132 may be disposed between the second gate electrode G2 and the second gate spacer 122. The second gate insulating layer 132 may be disposed between the second gate electrode G2 and the second plurality of nanosheets NW2. The second gate insulating layer 132 may be disposed between the second gate electrode G2 and the source/drain region SD.

Each of the first and second gate insulating layers 131, 132 may include at least one of silicon oxide, silicon oxynitride, silicon nitride, or a high-k dielectric material with a dielectric constant greater than that of silicon oxide. High-k dielectric materials may include, For example, one or more of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate.

The semiconductor device according to some example embodiments may include a NC (Negative Capacitance) FET utilizing a negative capacitor. For example, each of the first and second gate insulating layers 131, 132 may include a ferroelectric material layer having ferroelectric properties and a paraelectric material layer having paraelectric properties.

The ferroelectric material layer may have a negative capacitance, while the paraelectric material layer may have a positive capacitance. For example, when two or more capacitors are connected in series and each of their capacitances has a positive value, the overall capacitance is reduced compared to the capacitance of each individual capacitor. On the other hand, when at least one of the capacitances of the two or more capacitors connected in series has a negative value, the overall capacitance may have a positive value and be greater than the absolute value of each individual capacitance.

When the ferroelectric material layer having a negative capacitance and the paraelectric material layer having a positive capacitance are connected in series, the overall capacitance value of the ferroelectric material layer and the paraelectric material layer connected in series may increase. By utilizing the increase in overall capacitance value, the transistor including the ferroelectric material layer may have a subthreshold swing (SS) of less than 60 mV/decade at room temperature.

The ferroelectric material layer may have ferroelectric properties. The ferroelectric material layer may include, for example, at least one of hafnium oxide, hafnium zirconium oxide, barium strontium titanium oxide, barium titanium oxide, and lead zirconium titanium oxide. As another example, hafnium zirconium oxide may be a material in which zirconium (Zr) is doped into hafnium oxide. In another example, hafnium zirconium oxide may be a compound of hafnium (Hf) and zirconium (Zr) with oxygen (O).

The ferroelectric material layer may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). Depending on which ferroelectric material the ferroelectric material layer contains, the type of dopant included in the ferroelectric material layer may vary.

When the ferroelectric material layer includes hafnium oxide, the dopant included in the ferroelectric material layer may include, for example, at least one of gadolinium (Gd), silicon (Si), zirconium (Zr), aluminum (Al), and yttrium (Y).

When the dopant is aluminum (Al), the ferroelectric material layer may contain 3 to 8 at% (atomic %) of aluminum. Here, the proportion of the dopant may be a ratio of aluminum to the sum of hafnium and aluminum.

When the dopant is silicon (Si), the ferroelectric material layer may include 2 to 10 at% of silicon. When the dopant is yttrium (Y), the ferroelectric material layer may include 2 to 10 at% of yttrium. When the dopant is gadolinium (Gd), the ferroelectric material layer may include 1 to 7 at% of gadolinium. When the dopant is zirconium (Zr), the ferroelectric material layer may include 50 to 80 at% of zirconium.

The paraelectric material layer may have paraelectric properties. The paraelectric material layer may include, for example, at least one of silicon oxide and a high-k metal oxide. The metal oxide included in the paraelectric material layer may include, for example, at least one of hafnium oxide, zirconium oxide, and aluminum oxide, but is not limited thereto.

The ferroelectric material layer and the paraelectric material layer may contain the same material. While the ferroelectric material layer has ferroelectric properties, the paraelectric material layer may not have ferroelectric properties. For example, when the ferroelectric material layer and the paraelectric material layer contain hafnium oxide, the crystal structure of the hafnium oxide included in the ferroelectric material layer is different from the crystal structure of the hafnium oxide included in the paraelectric material layer.

The ferroelectric material layer may have a thickness having ferroelectric properties. The thickness of the ferroelectric material layer may be, for example, 0.5 to 10 nm, but is not limited thereto. Since each ferroelectric material may have a different critical thickness for exhibiting ferroelectric properties, the thickness of the ferroelectric material layer may vary depending on the specific ferroelectric material.

For example, each of the first and second gate insulating layers 131, 132 may include a single ferroelectric material layer. In another example, each of the first and second gate insulating layers 131, 132 may include a plurality of ferroelectric material layers spaced apart from each other. Each of the first and second gate insulating layers 131, 132 may have a stacked layer structure in which the plurality of ferroelectric material layers are alternately stacked with the plurality of paraelectric material layers.

The first etching stop layer 150 may be disposed on the sidewall of each of the first and second gate spacers 121, 122 in the first horizontal direction DR1. The first etching stop layer 150 may be disposed on the upper surface of the source/drain region SD. Although not shown, the first etching stop layer 150 may be disposed on the upper surface of the field insulating layer 115. Additionally, the first etching stop layer 150 may be disposed on the sidewall of the source/drain region SD in the second horizontal direction DR2. For example, the first etching stop layer 150 may be conformally formed. For example, the first etching stop layer 150 may include at least one of aluminum oxide, aluminum nitride, hafnium oxide, zirconium oxide, silicon oxide, silicon nitride, silicon oxynitride, and a low-k dielectric material.

The first capping pattern 141 may extend in the second horizontal direction DR2 on each of the first gate spacer 121, the first gate insulating layer 131, and the first gate electrode G1. The second capping pattern 142 may extend in the second horizontal direction DR2 on each of the second gate spacer 122, the second gate insulating layer 132, and the second gate electrode G2. For example, the bottom surface of each of the first and second capping patterns 141, 142 may be in contact with the first etching stop layer 150. However, the present disclosure is not limited thereto. In some other example embodiments, the sidewall of each of the first and second capping patterns 141, 142 may be in contact with the first etching stop layer 150. For example, each of the first and second capping patterns 141, 142 may include at least one of silicon nitride (SiN), silicon oxynitride (SiON), silicon oxide (SiO₂) silicon carbonitride (SiCN), silicon oxycarbonitride (SiOCN), and combinations thereof. However, the present disclosure is not limited thereto.

The first upper interlayer insulating layer 155 may be disposed on the first etching stop layer 150. The first upper interlayer insulating layer 155 may be disposed on the sidewall of each of the first and second capping patterns 141, 142. The first upper interlayer insulating layer 155 may cover the source/drain region SD on the field insulating layer 115. For example, the upper surface of the first upper interlayer insulating layer 155 may be formed on the same plane as the upper surface of each of the first and second capping patterns 141, 142. The first upper interlayer insulating layer 155 may include, for example, at least one of silicon oxide, silicon nitride, silicon oxynitride, and a low-k dielectric material.

The contact trench 160T may be formed beneath the source/drain region SD. The contact trench 160T penetrates the first lower interlayer insulating layer 110 and the insulating pattern 111 in the vertical direction DR3 and extend into the inside of the source/drain region SD. For example, both sidewalls of the contact trench 160T in the first horizontal direction DR1 may be defined by the first lower interlayer insulating layer 110 and the insulating pattern 111. Additionally, both sidewalls of the contact trench 160T in the first horizontal direction DR1 may be defined by the first lower interlayer insulating layer 110 and the field insulating layer 115. For example, the closer to the bottom surface of the first lower interlayer insulating layer 110, the width of the first horizontal direction DR1 and the width of the second horizontal direction DR2 of the contact trench 160T may each increase.

The source/drain contact 160 is disposed inside the contact trench 160T. For example, the source/drain contact 160 may completely fill the inside of the contact trench 160T. That is, the source/drain contact 160 may penetrate the first lower interlayer insulating layer 110 and the insulating pattern 111 in the vertical direction DR3 and extend into the inside of the source/drain region SD. The source/drain contact 160 is electrically connected to the source/drain region SD. For example, both sidewalls of the source/drain contact 160 in the first horizontal direction DR1 may be in contact with each of the first lower interlayer insulating layer 110 and the insulating pattern 111. For example, both sidewalls of the source/drain contact 160 in the second horizontal direction DR2 may be in contact with each of the first lower interlayer insulating layer 110 and the field insulating layer 115. For example, the closer to the bottom surface of the first lower interlayer insulating layer 110, the width of the first horizontal direction DR1 and the width of the second horizontal direction DR2 of the source/drain contact 160 may each increase. The silicide layer SL may be disposed along the interface between the source/drain region SD and the source/drain contact 160. For example, the silicide layer SL may include a metal silicide material. The source/drain contact 160 includes a barrier layer 161, a first filling layer 162, and a second filling layer 163.

The barrier layer 161 is disposed along a portion of the upper sidewalls and upper surface of the contact trench 160T. For example, the barrier layer 161 may be conformally formed. For example, the upper surface of the barrier layer 161 may be in contact with the silicide layer SL. That is, the silicide layer SL may be disposed along the interface between the source/drain region SD and the barrier layer 161. For example, the outer sidewall of the barrier layer 161 in the first horizontal direction DR1 is in contact with the insulating pattern 111. For example, the outer sidewall of the barrier layer 161 in the second horizontal direction DR2 may be in contact with the field insulating layer 115. For example, the barrier layer 161 may include at least one of tantalum (Ta), tantalum nitride (TaN), titanium (Ti), titanium nitride (TiN), ruthenium (Ru), cobalt (Co), aluminum (Al), molybdenum (Mo), nickel (Ni), nickel boron (NiB), tungsten (W), tungsten nitride (WN), tungsten carbonitride (WCN), zirconium (Zr), zirconium nitride (ZrN), vanadium (V), vanadium nitride (VN), niobium (Nb), niobium nitride (NbN), platinum (Pt), iridium (Ir), and rhodium (Rh).

The first filling layer 162 is disposed inside the contact trench 160T between the barrier layer 161. That is, at least a portion of the sidewalls of the first filling layer 162 may be surrounded by the barrier layer 161. For example, at least a portion of the first filling layer 162 may be disposed inside the source/drain region SD, that is, the uppermost surface of the first filling layer 162 may be formed higher than the bottom surface of the source/drain region SD. For example, the first filling layer 162 may be in contact with the lowermost surface of the barrier layer 161. For example. on the lowermost surface of the barrier layer 161, the sidewall of the first filling layer 162 in the first horizontal direction DR1 may be in contact with the insulating pattern 111. Additionally, on the lowermost surface of the barrier layer 161, the sidewall of the first filling layer 162 in the second horizontal direction DR2 may be in contact with the field insulating layer 115.

For example, the bottom surface 162a of the first filling layer 162 may be formed higher than the upper surface of the first lower interlayer insulating layer 110. However, the present disclosure is not limited thereto. In some other example embodiments, the bottom surface 162a of the first filling layer 162 may be formed between the bottom surface of the first lower interlayer insulating layer 110 and the upper surface of the first lower interlayer insulating layer 110. As shown in FIG. 3, the first filling layer 162 is formed of multi grain. That is, the first filling layer 162 include a plurality of first grains GR1. The first filling layer 162 has a first average grain size in the first horizontal direction DR1, that is, the plurality of first grains GR1 included in the first filling layer 162 have a first average grain size in the first horizontal direction DR1. The first average grain size may be an average value of the plurality of first grains GR1 included in the first filling layer 162.

The second filling layer 163 fills the inside of the contact trench 160T under the bottom surface of the first filling layer 162. For example, the upper surface of the second filling layer 163 may be in contact with the bottom surface of the first filling layer 162. For example, both sidewalls of the second filling layer 163 in the first horizontal direction DR1 may be in contact with each of the first lower interlayer insulating layer 110 and the insulating pattern 111. Additionally, both sidewalls of the second filling layer 163 in the first horizontal direction DR1 may be in contact with each of the first lower interlayer insulating layer 110 and the field insulating layer 115. For example, the sidewall of the second filling layer 163 in the first horizontal direction DR1 being in contact with the insulating pattern 111, the sidewall of the first filling layer 162 in the first horizontal direction DR1 being in contact with the insulating pattern 111, and the outer sidewall of the barrier layer 161 in the first horizontal direction DR1 being in contact with the insulating pattern 111 may each be aligned, respectively.

For example, the lowermost surface of the barrier layer 161 may overlap with the upper surface of the second filling layer 163 in the vertical direction DR3. For example, the lowermost surface of the barrier layer 161 may be spaced apart from the upper surface of the second filling layer 163 in the vertical direction DR3. For example, the upper surface of the second filling layer 163 may be formed higher than the upper surface of the first lower interlayer insulating layer 110. However, the present disclosure is not limited thereto. In some other example embodiments, the upper surface of the second filling layer 163 may be formed between the bottom surface of the first lower interlayer insulating layer 110 and the upper surface of the first lower interlayer insulating layer 110. For example, the bottom surface of the second filling layer 163 may be formed to be convex toward the bottom via 170. For example, the bottom surface of the second filling layer 163 may be formed lower than the bottom surface of the first lower interlayer insulating layer 110. That is, the lowermost surface 163a of the second filling layer 163 may be formed lower than the bottom surface of the first lower interlayer insulating layer 110. The second filling layer 163 is formed of single grain.

The via trench 170T may be formed beneath the source/drain contact 160. The via trench 170T may be formed inside the second lower interlayer insulating layer 100. The via trench 170T may penetrate the second lower interlayer insulating layer 100 in the vertical direction DR3 and extend into the bottom surface of the first lower interlayer insulating layer 110. For example, the closer to the bottom surface of the second lower interlayer insulating layer 100, the width in the first horizontal direction DR1 and the width in the second horizontal direction DR2 of the via trench 170T may each increase. For example, the width of the via trench 170T in the first horizontal direction DR1 may be greater than the width of the contact trench 160T in the first horizontal direction DR1. Further, the width of the via trench 170T in the second horizontal direction DR2 may be greater than the width of the contact trench 160T in the second horizontal direction DR2.

The bottom via 170 may be disposed inside the via trench 170T. For example, at least a portion of the second filling layer 163 may be disposed inside of the via trench 170T. The bottom via 170 may be in contact with the bottom surface of the source/drain contact 160. In other words, the bottom via 170 may be in contact with the bottom surface of the second filling layer 163. The bottom via 170 may fill the inside of the via trench 170T on the bottom surface of the second filling layer 163. For example, the width of the bottom via 170 in the first horizontal direction DR1 may be greater than the width of the source/drain contact 160 in the first horizontal direction DR1. Furthermore, the width of the bottom via 170 in the second horizontal direction DR2 may be greater than the width of the source/drain contact 160 in the second horizontal direction DR2. For example, at least a portion of the upper surface of the bottom via 170 may be in contact with the bottom surface of the first lower interlayer insulating layer 110.

For example, as shown in FIG. 3, the bottom via 170 may be formed of multi grain. That is, the bottom via 170 may include a plurality of second grains GR2. For example, the bottom via 170 may have a second average grain size in the first horizontal direction DR1. That is, the plurality of second grains GR2 included in the bottom via 170 may have a second average grain size in the first horizontal direction DR1. The second average grain size may be the average value of the plurality of second grains GR2 included in the bottom via 170. For example, the second average grain size of the plurality of second crystals GR2 included in the bottom via 170 may be greater than the first average grain size of the plurality of first grains GR1 included in the first filling layer 162. For example, the second average grain size of the plurality of second grains GR2 included in the bottom via 170 may be at least 1.5 times greater than the first average grain size of the plurality of first grains GR1 included in the first filling layer 162.

For example, each of the first filling layer 162, the second filling layer 163, and the bottom via 170 may include any one of molybdenum (Mo), tungsten (W), ruthenium (Ru), iridium (Ir), cobalt (Co), and copper (Cu). In some example embodiments, the first filling layer 162, the second filling layer 163, and the bottom via 170 may include the same material as each other. In some other example embodiments, any one of the first filling layer 162, the second filling layer 163, and the bottom via 170 may include a different material. In yet some other example embodiments, the first filling layer 162, the second filling layer 163, and the bottom via 170 may each include different materials

The first gate contact CB1 may penetrate the first capping pattern 141 in the vertical direction DR3 to connect to the first gate electrode G1. The second gate contact CB2 may penetrate the second capping pattern 142 in the vertical direction DR3 to connect to the second gate electrode G2. Each of the first and second gate contacts CB1, CB2 may include a conductive material. The second etching stop layer 180 may be disposed on the upper surface of the first upper interlayer insulating layer 155 and the upper surfaces of the first and second gate contacts CB1, CB2, respectively. In FIGS. 2, 4, and 5, the second etching stop layer 180 is shown as being formed of a single layer, but the present disclosure is not limited thereto. In some other example embodiments, the second etching stop layer 180 may be formed as multiple layers. The second etching stop layer 180 may include at least one of, for example, aluminum oxide, aluminum nitride, hafnium oxide, zirconium oxide, silicon oxide, silicon nitride, silicon oxynitride, and a low-k dielectric material.

The second upper interlayer insulating layer 185 may be disposed on the second etching stop layer 180. The second upper interlayer insulating layer 185 may include at least one of, for example, silicon oxide, silicon nitride, silicon oxynitride, and a low-k dielectric material. The first upper via V1 may penetrate the second upper interlayer insulating layer 185 and the second etching stop layer 180 in the vertical direction DR3 to connect to the first gate contact CB 1. The second upper via V2 may penetrate the second upper interlayer insulating layer 185 and the second etching stop layer 180 in the vertical direction DR3 to connect to the second gate contact CB2. Each of the first and second upper vias V1, V2 may include a conductive material.

The semiconductor device according to example embodiments of the present disclosure has a source/drain contact 160 including a first filling layer 162 formed of multi grain and a second filling layer 163 formed of single grain. Further, the bottom via 170 connecting to the source/drain contact 160 may be formed of multi grain. Accordingly, the semiconductor device according to some example embodiments of the present disclosure may reduce defects formed in each of the first filling layer 162, the second filling layer 163, and the bottom via 170. Additionally, the semiconductor device according to some example embodiments of the present disclosure may reduce the resistance between the first filling layer 162, the second filling layer 163, and the bottom via 170. When the average grain size GR2 of the grains included in the bottom via 170 is at least 1.5 times the average size GR1 of the grains in the first filling layer 162, then the defects formed may be further reduced and/ or the resistance between the first filling layer 162, the second filling layer 163, and the bottom via 170, may be further reduced.

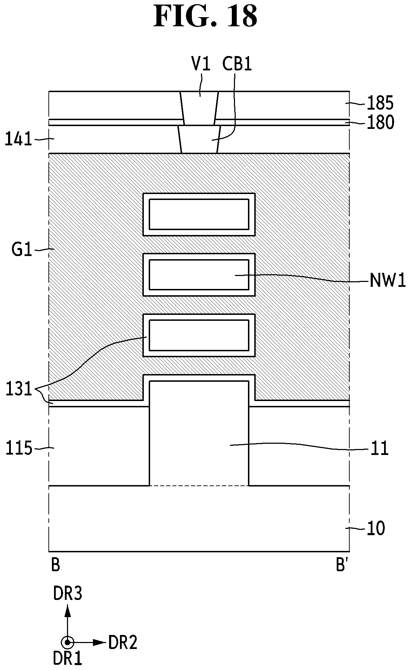

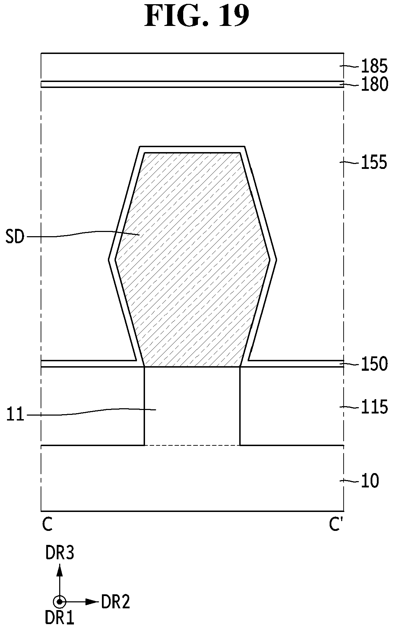

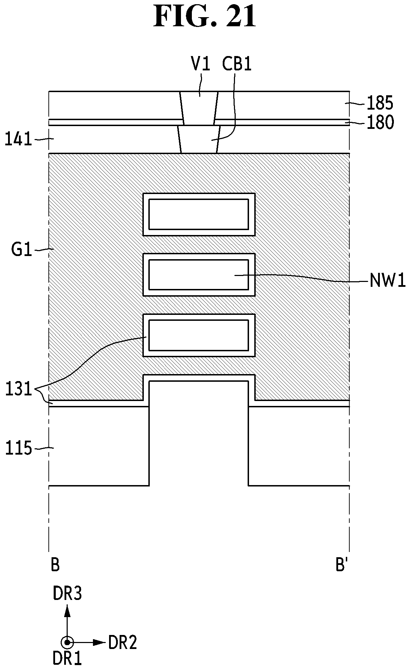

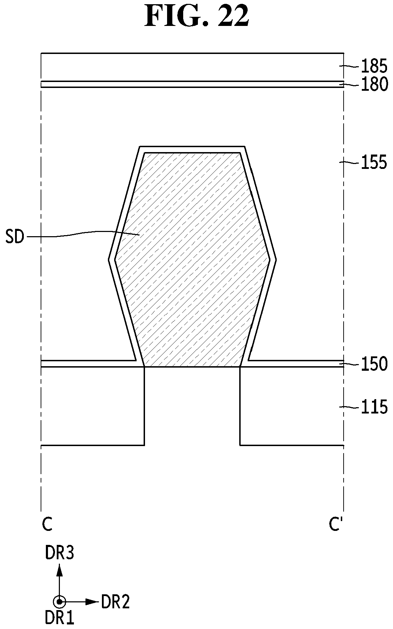

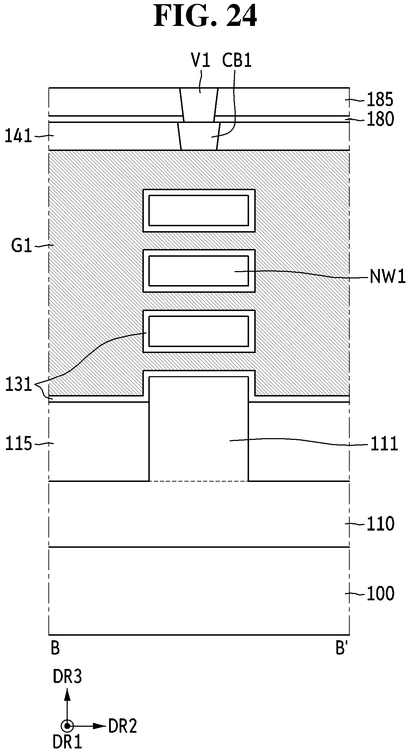

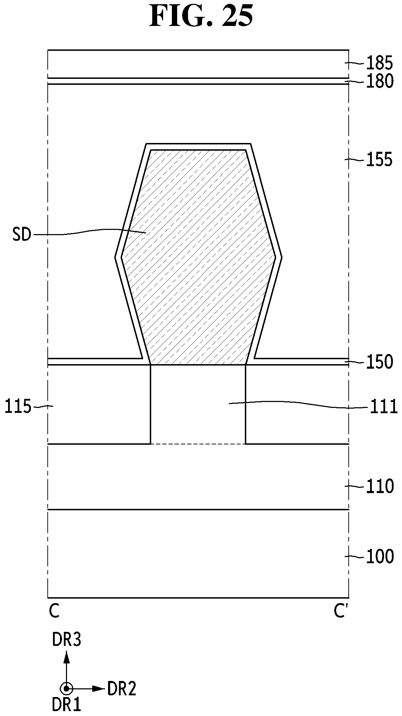

Hereinafter, the fabrication method of a semiconductor device according to some example embodiments of the present disclosure will be described with reference to FIGS. 2 to 33.

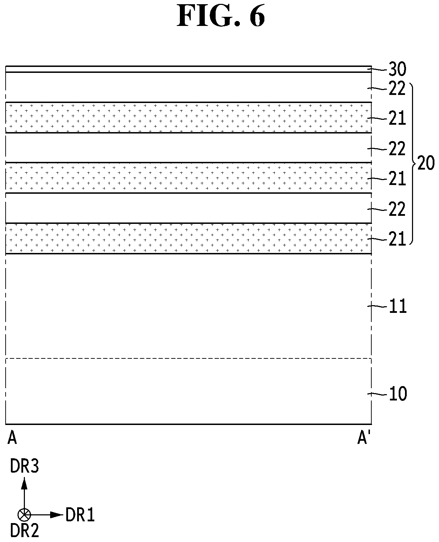

FIGS. 6 to 33 are intermediate stage drawings for explaining the fabrication method of a semiconductor device according to some example embodiments of the present disclosure.

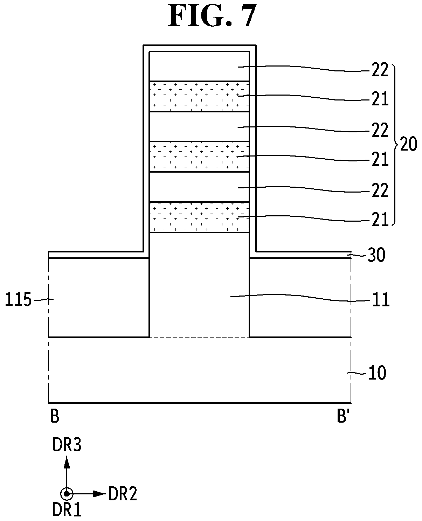

Referring to FIGS. 6 and 7, the substrate 10 may be a silicon substrate or SOI (silicon-on-insulator). Alternatively, the substrate 10 may include silicon germanium, SGOI (silicon germanium on insulator), indium antimonide, lead tellurium compound, indium arsenide, indium phosphide, gallium arsenide, or gallium antimonide. However, the present disclosure is not limited thereto.

Subsequently, a stacked structure 20 may be formed on the substrate 10. The stacked structure 20 may include a first semiconductor layer 21 and a second semiconductor layer 22 alternately stacked on the substrate 10. For example, the first semiconductor layer 21 may be formed at the lowermost portion of the stacked structure 20, and the second semiconductor layer 22 may be formed at the uppermost portion of the stacked structure 20. However, the present disclosure is not limited thereto. In some other example embodiments, the first semiconductor layer 21 may also be formed at the uppermost portion of the stacked structure 20. The first semiconductor layer 21 may include, for example, silicon germanium (SiGe). The second semiconductor layer 22 may include, for example, silicon (Si).

Subsequently, a portion of the stacked structure 20 may be etched. While the stacked structure 20 is being etched, a portion of the substrate 10 may also be etched. Through such an etching process, an active pattern 11 may be defined beneath the stacked structure 20 on the upper surface of the substrate 10. The active pattern 11 may protrude in the vertical direction DR3 from the upper surface of the substrate 10. The active pattern 11 may extend in the first horizontal direction DR1. For example, the active pattern 11 may include silicon (Si).

Next, a field insulating layer 115 may be formed on the upper surface of the substrate 10. The field insulating layer 115 may surround the sidewall of the active pattern 11. For example, the upper surface of the field insulating layer 115 may be formed lower than the upper surface of the active pattern 11. Subsequently, a pad oxide layer 30 may be formed to cover the upper surface of the field insulating layer 115, the exposed sidewalls of the active pattern 11, and the sidewalls and upper surface of the stacked structure 20. For example, the pad oxide layer 30 may be conformally formed. The pad oxide layer 30 may include, for example, silicon oxide (SiO₂).

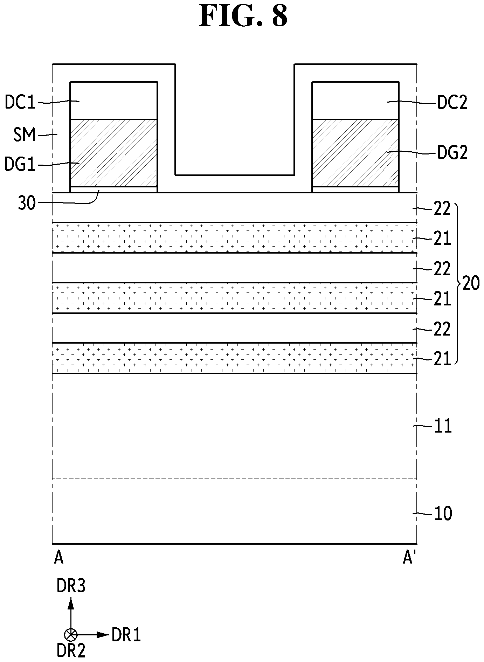

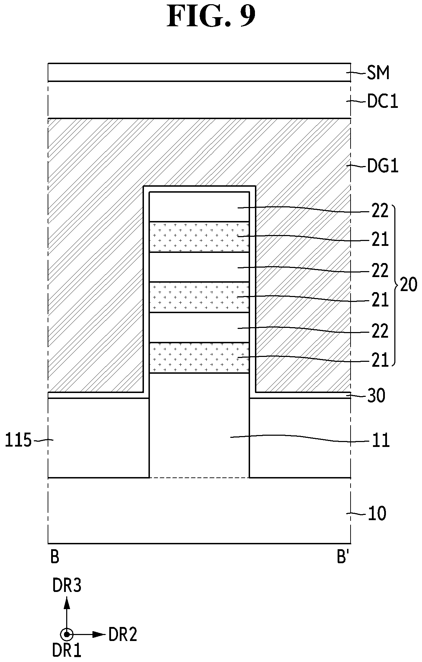

Referring to FIGS. 8 and 9, first and second dummy gates DG1, DG2 and first and second dummy capping patterns DC1, DC2 extending in the second horizontal direction DR2 may be formed on the pad oxide layer 30 on the stacked structure 20 and field insulating layer 115. For example, the second dummy gate DG2 may be spaced apart from the first dummy gate DG1 in the first horizontal direction DR1. The first dummy capping pattern DC1 may be disposed on the first dummy gate DG1. The second dummy capping pattern DC2 may be disposed on the second dummy gate DG2. While the first and second dummy gates DG1, DG2 and the first and second dummy capping patterns DC1, DC2 are being formed, the remaining portion of the pad oxide layer 30 except for the portion overlapping in the vertical direction DR3 with each of the first and second dummy gates DG1, DG2 may be removed on the substrate 10.

Subsequently, a spacer material layer SM may be formed to cover the sidewalls of each of the first and second dummy gates DG1, DG2, the sidewalls and upper surfaces of each of the first and second dummy capping patterns DC1, DC2, the exposed sidewalls and upper surfaces of the stacked structure 20, and the upper surface of the field insulating layer 115. For example, the spacer material layer SM may be conformally formed. The spacer material layer SM may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and combinations thereof.

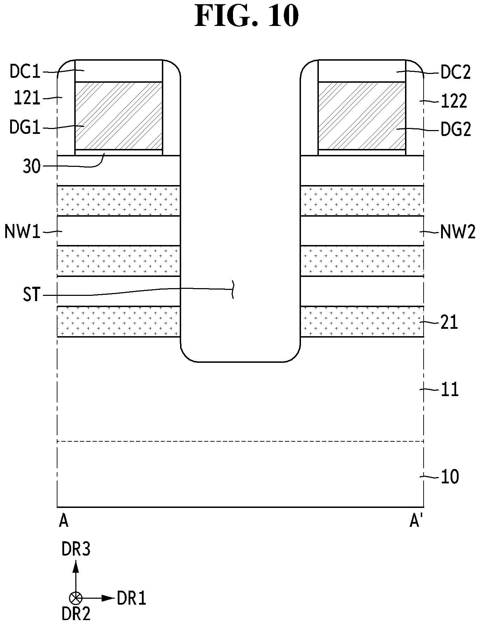

Referring to FIG. 10, the stacked structure 20 (see FIG. 8) may be etched using the first and second dummy gates DG1, DG2 and the first and second dummy capping patterns DC1, DC2 as masks to form a source/drain trench ST. The source/drain trench ST may be formed between the first dummy gate DG1 and the second dummy gate DG2 on the active pattern 11. For example, the source/drain trench ST may extend into the inside of the active pattern 11. For example, while the source/drain trench ST is being formed, the spacer material layer SM (see FIG. 8) formed on the upper surface of each of the first and second dummy capping patterns DC1, DC2 and a portion of each of the first and second dummy capping patterns DC1, DC2 may be etched.

The spacer material layer SM (see FIG. 8) remaining on the sidewall of each of the first and second dummy capping patterns DC1, DC2 and the first and second dummy gates DG1, DG2 may be defined as the first and second gate spacers 121, 122. For example, after the source/drain trench ST is formed, the second semiconductor layer 22 (see FIG. 8) remaining beneath the first dummy gate DG1 may be defined as the first plurality of nanosheets NW1. After the source/drain trench ST is formed, the second semiconductor layer 22 (see FIG. 8) remaining beneath the second dummy gate DG2 may be defined as the second plurality of nanosheets NW2.

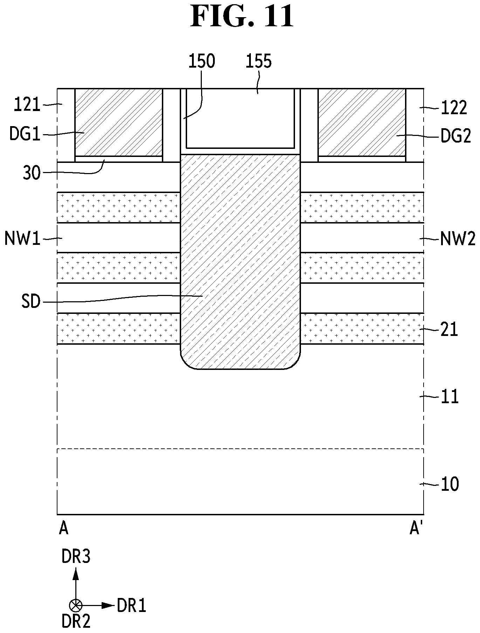

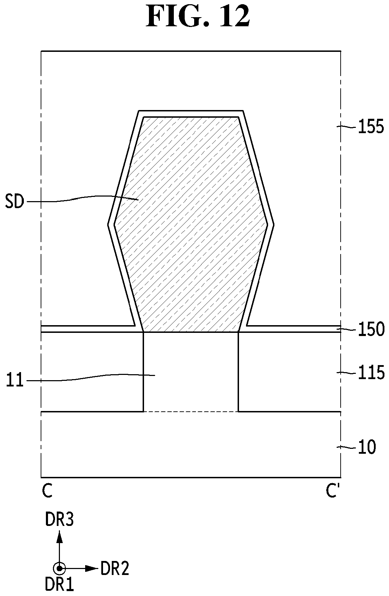

Referring to FIGS. 11 and 12, the source/drain region SD may be formed inside of the source/drain trench ST (see FIG. 10). For example, the bottom surface of the source/drain region SD may be in contact with the active pattern 11. Subsequently, the first etching stop layer 150 may be formed on the upper surface of the exposed field insulating layer 115, the sidewall of each of the exposed first and second gate spacers 121, 122, the upper surface of each of the exposed first and second dummy capping patterns DC1, DC2 (see FIG. 10), and the surface of the exposed source/drain region SD. Subsequently, the first upper interlayer insulating layer 155 may be formed on the first etching stop layer 150. Subsequently, a planarization process may be performed so that the upper surface of each of the first and second dummy gates DG1, DG2 may be exposed. The source/drain region SD may include a semiconductor material (e.g., silicon, silicon germanium) and may be doped with impurities to be electrically conductive.

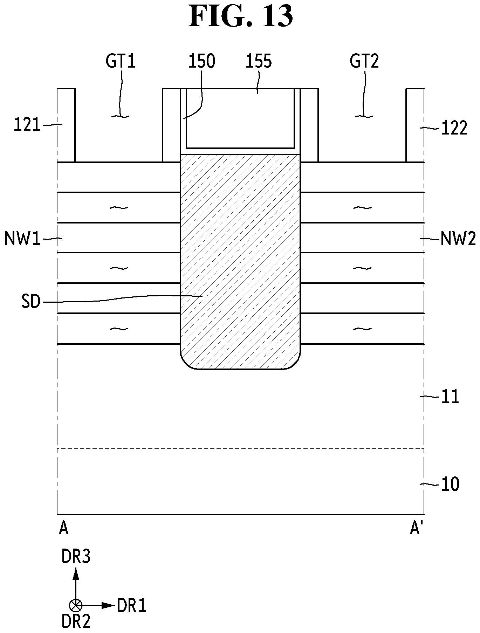

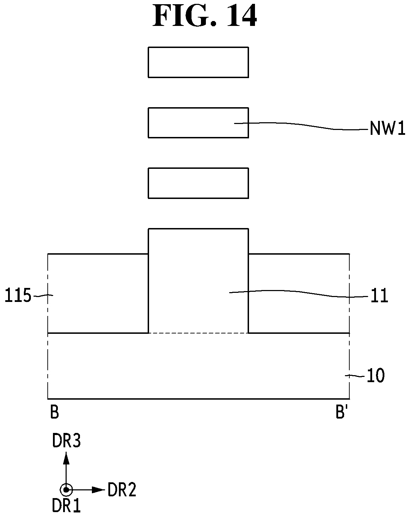

Referring to FIGS. 13 and 14, the first and second dummy gates DG1, DG2 (see FIG. 11), the pad oxide layer 30 (see FIG. 11), and the first semiconductor layer 21 (see FIG. 11) may be etched, respectively. The portion in which the first dummy gate DG1 (see FIG. 11), the pad oxide layer 30 (see FIG. 11), and the first semiconductor layer 21 (see FIG. 11) are etched may be defined as the first gate trench GT1. Additionally, the portion in which the second dummy gate DG2 (see FIG. 11), the pad oxide layer 30 (see FIG. 11), and the first semiconductor layer 21 (see FIG. 11) are etched may be defined as the second gate trench GT2.

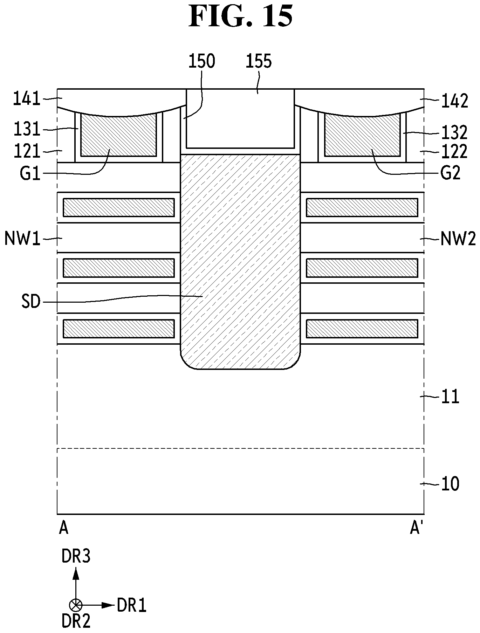

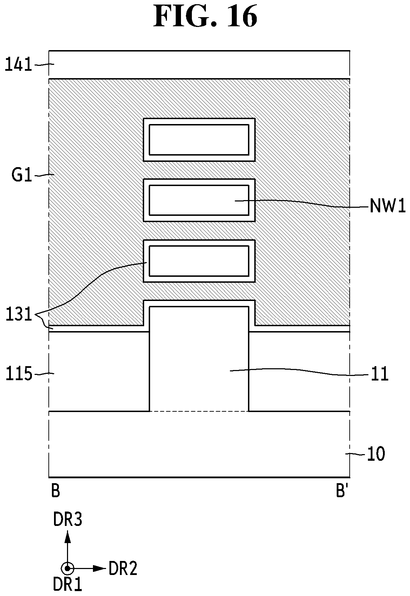

Referring to FIGS. 15 and 16, the first gate insulating layer 131, the first gate electrode G1, and the first capping pattern 141 may each be formed sequentially inside the first gate trench GT1 (see FIG. 13). Further, the second gate insulating layer 132, the second gate electrode G2, and the second capping pattern 142 may each be formed sequentially inside the second gate trench GT2 (see FIG. 13). For example, the first gate electrode G1 may surround the first plurality of nanosheets NW1. The second gate electrode G2 may surround the second plurality of nanosheets NW2.

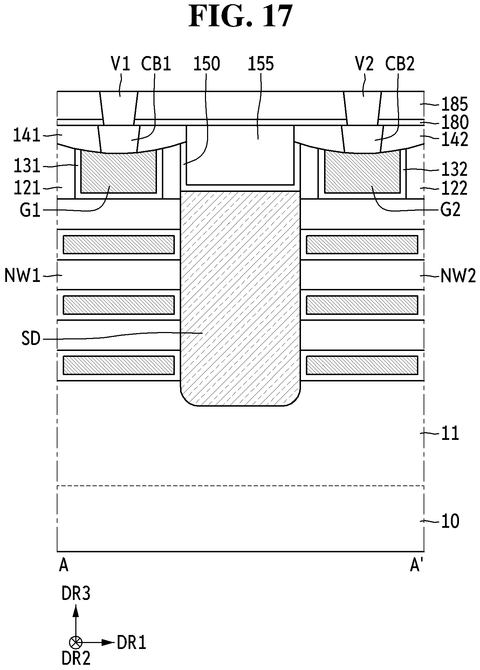

Referring to FIGS. 17 to 19, the first gate contact CB1, which penetrates the first capping pattern 141 in the vertical direction DR3 and connects to the first gate electrode G1, may be formed. Additionally, the second gate contact CB2, which penetrates the second capping pattern 142 in the vertical direction DR3 and connects to the second gate electrode G2, may be formed. Subsequently, the second etching stop layer 180 and the second upper interlayer insulating layer 185 may be formed sequentially on the upper surface of each of the first upper interlayer insulating layer 155 and the first and second gate contacts CB1, CB2. Subsequently, the first upper via V1, which penetrates the second etching stop layer 180 and the second upper interlayer insulating layer 185 in a vertical direction DR3 and connects to the first gate contact CB1, may be formed. Additionally, the second upper via V2, which penetrates the second etching stop layer 180 and the second upper interlayer insulating layer 185 in the vertical direction DR3 and connects to the second gate contact CB2, may be formed.

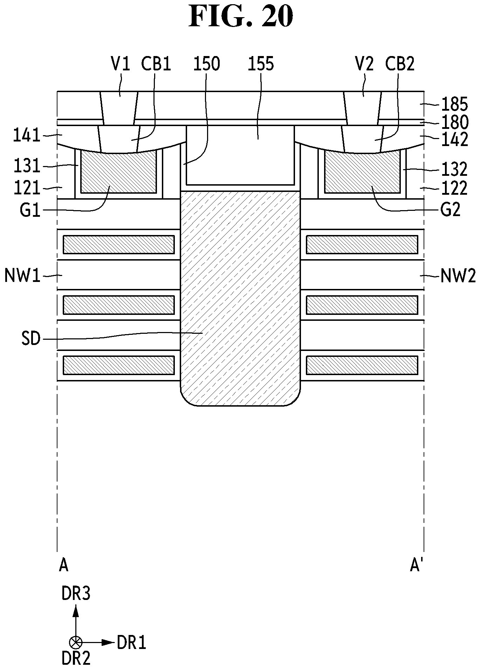

Referring to FIGS. 20 to 22, the substrate 10 (see FIGS. 17 to 19) and the active pattern 11 (see FIGS. 17 to 19) may each be etched.

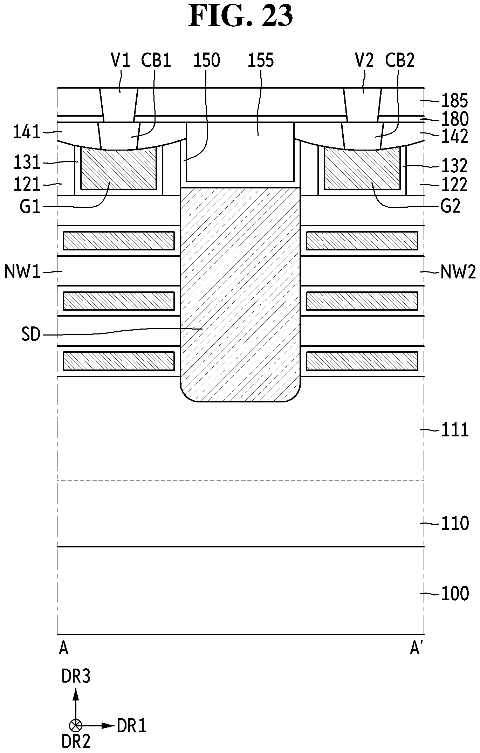

Referring to FIGS. 23 to 25, the insulating pattern 111 may be formed on the portion where the active pattern 11 (see FIGS. 17 to 19) is etched. The insulating pattern 111 may extend in the first horizontal direction DR1. Additionally, the first lower interlayer insulating layer 110 may be formed on the bottom surface of each of the insulating pattern 111 and the field insulating layer 115. For example, the insulating pattern 111 and the first lower interlayer insulating layer 110 may be formed through the same fabrication process. Subsequently, the second lower interlayer insulating layer 100 may be formed on the bottom surface of the first lower interlayer insulating layer 110.

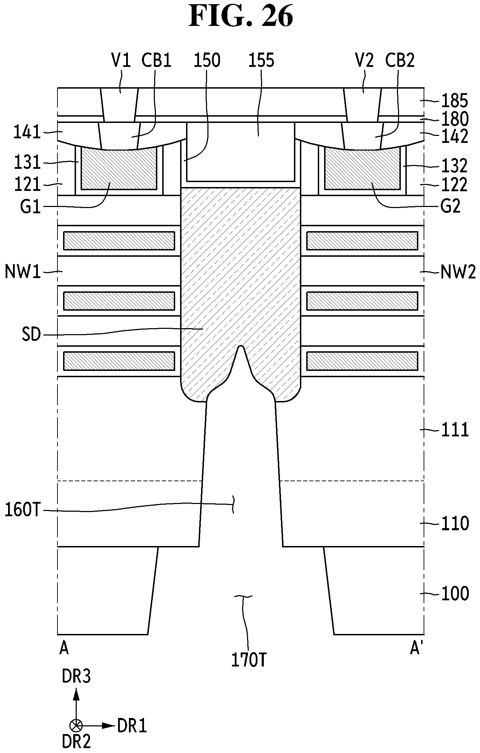

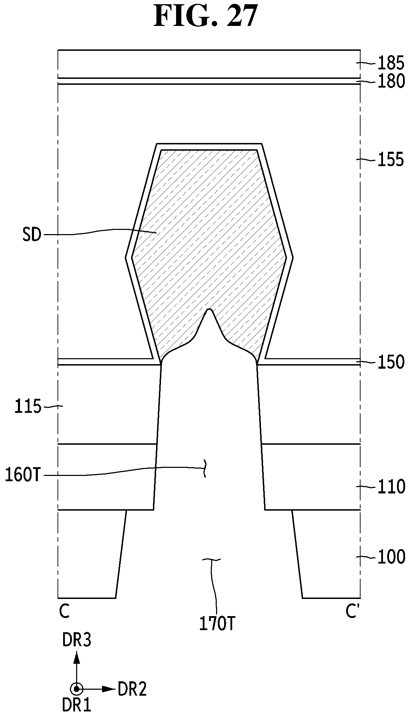

Referring to FIGS. 26 and 27, the via trench 170T may be formed inside the second lower interlayer insulating layer 100. The contact trench 160T may be formed on the via trench 170T. The contact trench 160T may penetrate the first lower interlayer insulating layer 110 and the insulating pattern 111 in the vertical direction DR3 to extend into the inside of the source/drain region SD. For example, the via trench 170T and the contact trench 160T may be formed through the same fabrication process.

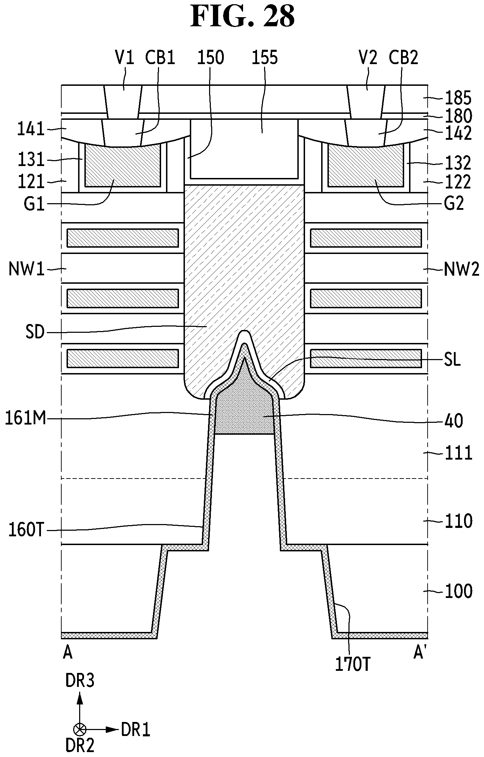

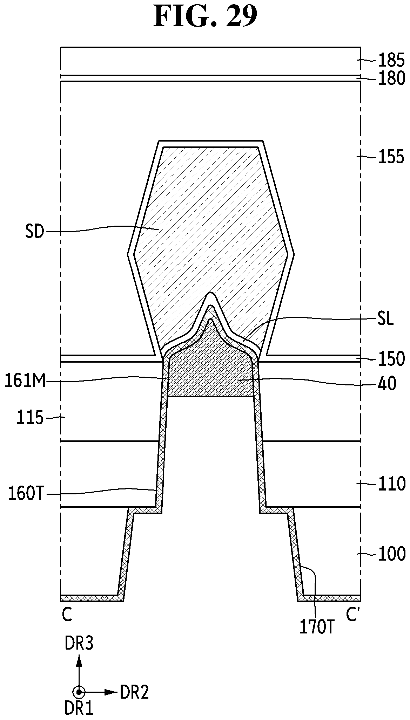

Referring to FIGS. 28 and 29, the silicide layer SL may be formed on the surface of the source/drain region SD exposed through the contact trench 160T. Subsequently, a barrier material layer 161M may be formed on the surface of the contact trench 160T, the surface of the via trench 170T, and the bottom surface of the second lower interlayer insulating layer 100. For example, the barrier material layer 161M may be conformally formed. Next, a sacrificial layer 40 may be formed inside the contact trench 160T. For example, the bottom surface of the sacrificial layer 40 may be formed higher than the upper surface of the first lower interlayer insulating layer 110. For example, the sacrificial layer 40 may include a SOH (Spin-On Hardmask).

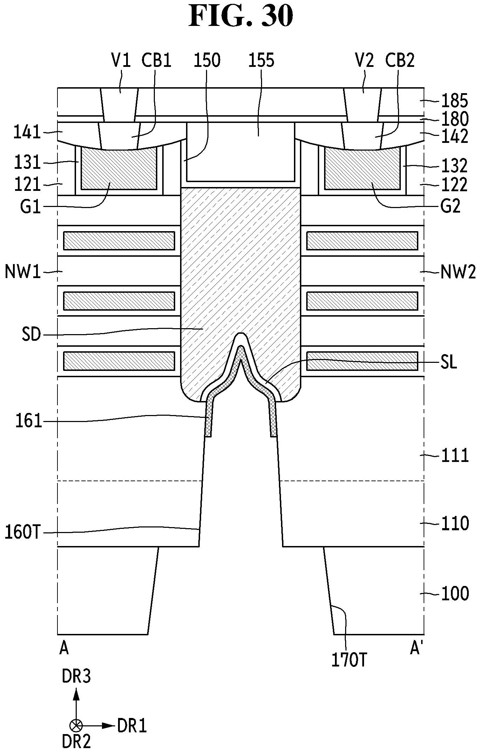

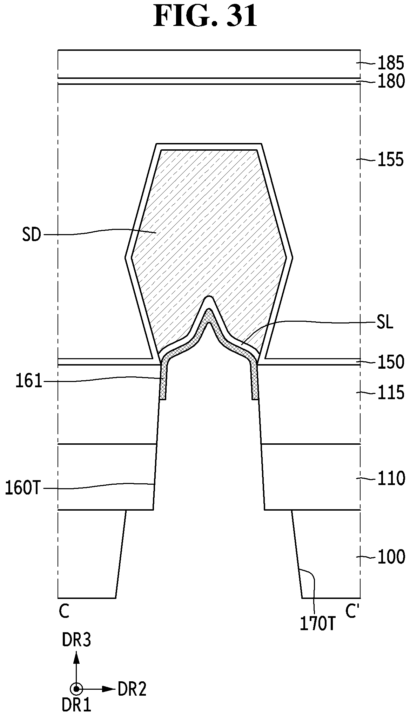

Referring to FIGS. 30 and 31, a portion of the barrier material layer 161M (see FIGS. 28 and 29) exposed on the bottom surface of the sacrificial layer 40 may be etched. After a portion of the barrier material layer 161M (see FIGS. 28 and 29) is etched, the remaining barrier material layer 161M (see FIGS. 28 and 29) may be defined as the barrier layer 161. Subsequently, the sacrificial layer 40 (see FIGS. 28 and 29) may be etched.

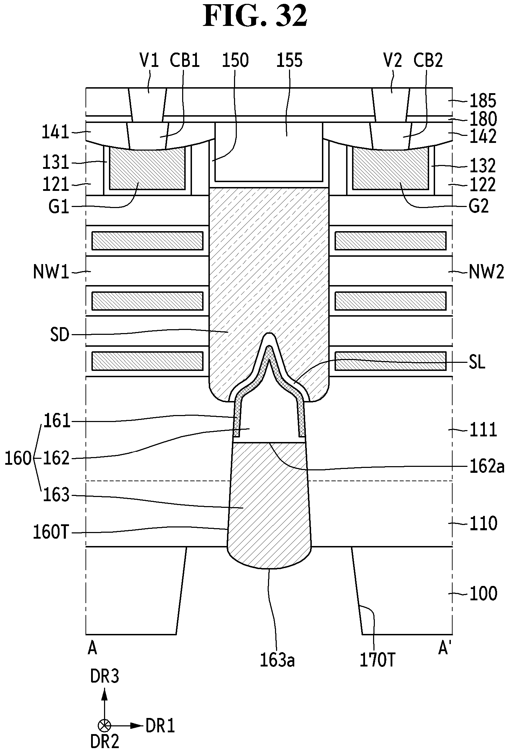

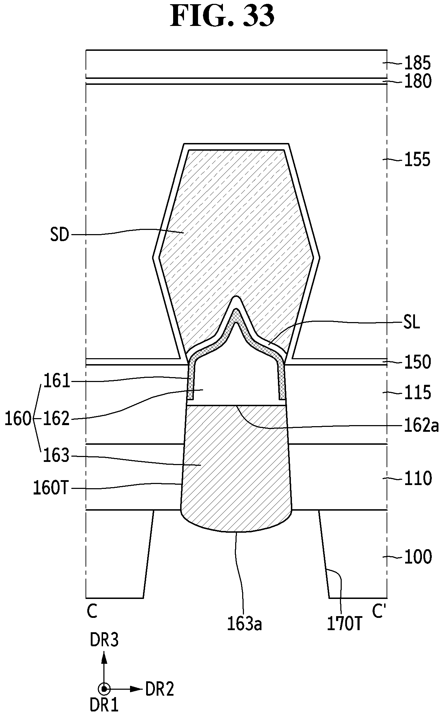

Referring to FIGS. 32 and 33, the first filling layer 162 may be formed between the barrier layer 161 inside the contact trench 160T. For example, the first filling layer 162 may be formed by growing out of the barrier layer 161. For example, the first filling layer 162 may be formed of multi grain. For example, the first filling layer 162 may be formed on the lowermost surface of the barrier layer 161. That is, the bottom surface 162a of the first filling layer 162 may be formed lower than the lowermost surface of the barrier layer 161.

Subsequently, the second filling layer 163 may be formed to fill the inside of the contact trench 160T on the bottom surface 162a of the first filling layer 162. For example, the second filling layer 163 may be formed by growing out of the first filling layer 162. For example, the second filling layer 163 may be formed of single grain. For example, at least a portion of the second filling layer 163 may be formed inside the via trench 170T. In other words, the lowermost surface 163a of the second filling layer 163 may be formed lower than the bottom surface of the first lower interlayer insulating layer 110. Through such a fabrication process, the source/drain contact 160 including the barrier layer 161, the first filling layer 162, and the second filling layer 163 may be formed inside the contact trench 160T.

Referring to FIGS. 2 to 5, the bottom via 170 may be formed inside the via trench 170T. For example, the bottom via 170 may be formed by growing out of the second filling layer 163. For example, the bottom via 170 may be formed of multi grain. Through such a fabrication process, the semiconductor device shown in FIGS. 2 to 5 may be fabricated.

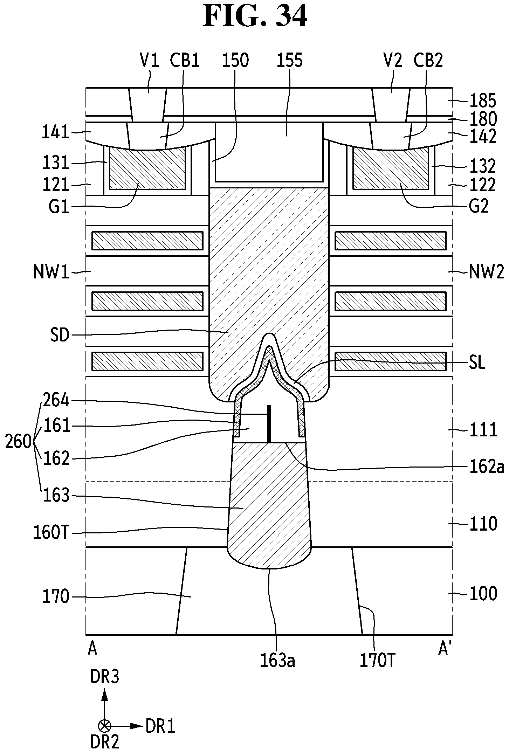

Hereinafter, a semiconductor device according to several other example embodiments of the present disclosure will be described with reference to FIG. 34. The description will emphasize the differences from the semiconductor device shown in FIGS. 1 to 5.

FIG. 34 is a cross-sectional view for explaining a semiconductor device according to some example embodiments of the present disclosure.

Referring to FIG. 34, in a semiconductor device according to some example embodiments of the present disclosure, the source/drain contact 260 may include a seam pattern 264.

For example, the seam pattern 264 may be disposed inside the first filling layer 162. The seam pattern 264 may be spaced apart from the barrier layer 161. The seam pattern 264 may be in contact with the upper surface of the second filling layer 163.

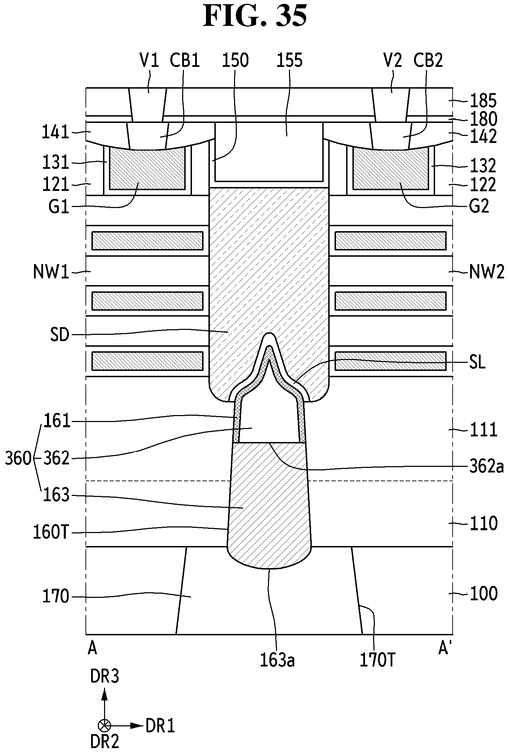

Hereinafter, a semiconductor device according to some other example embodiments of the present disclosure will be described with reference to FIG. 35. The description will emphasize the differences from the semiconductor device shown in FIGS. 1 to 5.

FIG. 35 is a cross-sectional view for explaining a semiconductor device according to another several example embodiments of the present disclosure.

Referring to FIG. 35, in a semiconductor device according to some other example embodiments of the present disclosure, the lowermost surface of the barrier layer 161 may be in contact with the upper surface of the second filling layer 163.

The source/drain contact 360 include the barrier layer 161, the first filling layer 362, and the second filling layer 163. For example, the first filling layer 362 is not disposed between the lowermost surface of the barrier layer 161 and the upper surface of the second filling layer 163. The first filling layer 362 may be spaced apart from the insulating pattern 111. In some example embodiments, the bottom surface 362a of the first filling layer 362 may be formed on the same plane as the lowermost surface of the barrier layer 161. In some other example embodiments, the bottom surface 362a of the first filling layer 362 may be formed lower than the lowermost surface of the barrier layer 161.

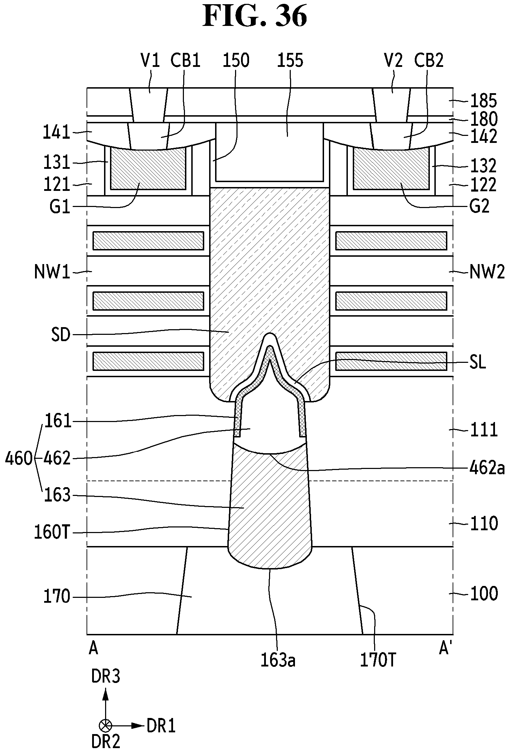

Hereinafter, a semiconductor device according to some other example embodiments of the present disclosure will be described with reference to FIG. 36. The description will emphasize the differences from the semiconductor device shown in FIGS. 1 to 5.

FIG. 36 is a cross-sectional view for explaining a semiconductor device according to another several example embodiments of the present disclosure.

Referring to FIG. 36, in a semiconductor device according to some other example embodiments of the present disclosure, the bottom surface 462a of the first filling layer 462 may be formed to be convex toward the second filling layer 163. The source/drain contact 460 includes the barrier layer 161, the first filling layer 462, and the second filling layer 163.

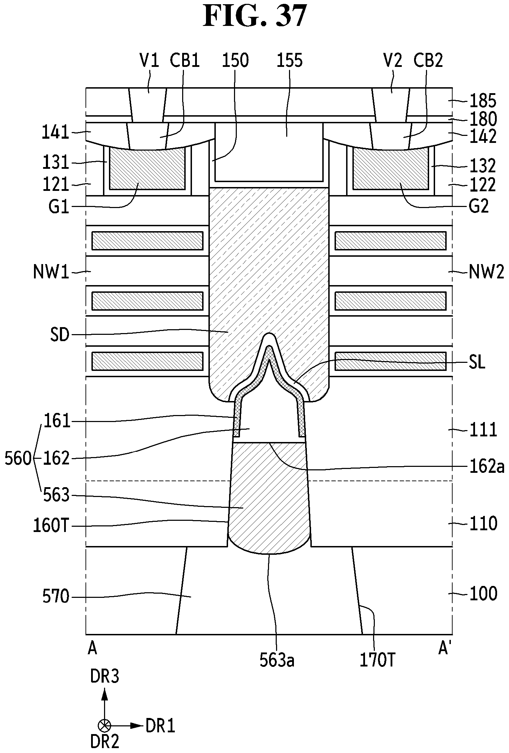

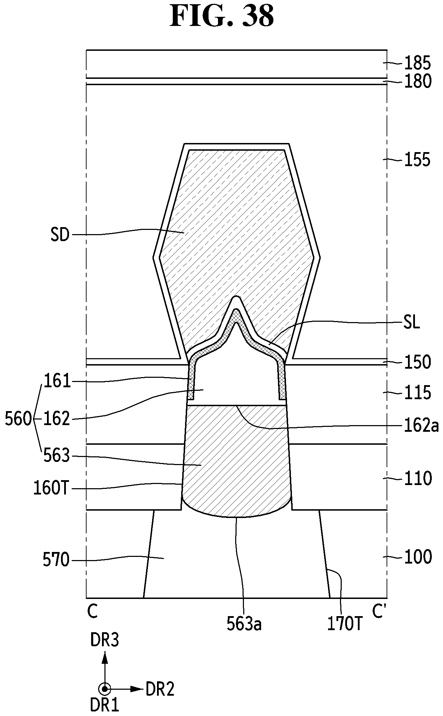

Hereinafter, a semiconductor device according to several other example embodiments of the present disclosure will be described with reference to FIGS. 37 and 38. The description will focus on the differences from the semiconductor device shown in FIGS. 1 to 5.

FIGS. 37 and 38 are cross-sectional views for explaining a semiconductor device according to yet some other example embodiments of the present disclosure.

Referring to FIGS. 37 and 38, in a semiconductor device according to some other example embodiments of the present disclosure, at least a portion of the bottom via 570 may be disposed inside the contact trench 160T.

For example, inside the contact trench 160T, the sidewall of the bottom via 570 in the first horizontal direction DR1 may be in contact with the first lower interlayer insulating layer 110. Additionally, inside the contact trench 160T, the sidewall of the bottom via 570 in the second horizontal direction DR2 may be in contact with the first lower interlayer insulating layer 110. For example, the source/drain contact 560 may include the barrier layer 161, the first filling layer 162, and the second filling layer 563. For example, the lowermost surface 563a of the second filling layer 563 may be formed lower than the bottom surface of the first lower interlayer insulating layer 110.

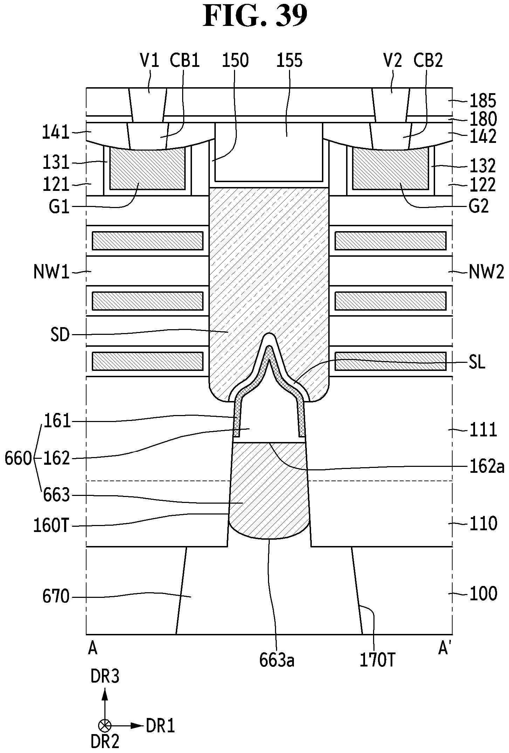

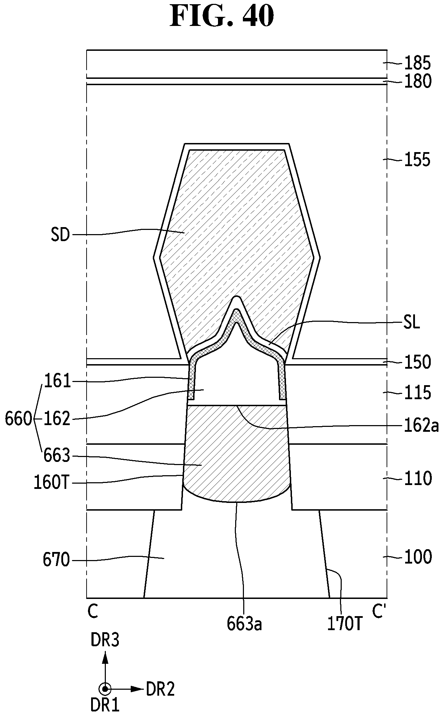

Hereinafter, a semiconductor device according to some other example embodiments of the present disclosure will be described with reference to FIGS. 39 and 40. The description will focus on the differences from the semiconductor device shown in FIGS. 1 to 5.

FIGS. 39 and 40 are cross-sectional views for explaining a semiconductor device according to some other example embodiments of the present disclosure.

Referring to FIGS. 39 and 40, in a semiconductor device according to some other example embodiments of the present disclosure, the lowermost surface 663a of the second filling layer 663 may be formed higher than the bottom surface of the first lower interlayer insulating layer 110.

For example, inside the contact trench 160T, the sidewall of the bottom via 670 in the first horizontal direction DR1 may be in contact with the first lower interlayer insulating layer 110. Additionally, inside the contact trench 160T, the sidewall of the bottom via 670 in the second horizontal direction DR2 may be in contact with the first lower interlayer insulating layer 110. For example, the source/drain contact 660 may include the barrier layer 161, the first filling layer 162, and the second filling layer 663.

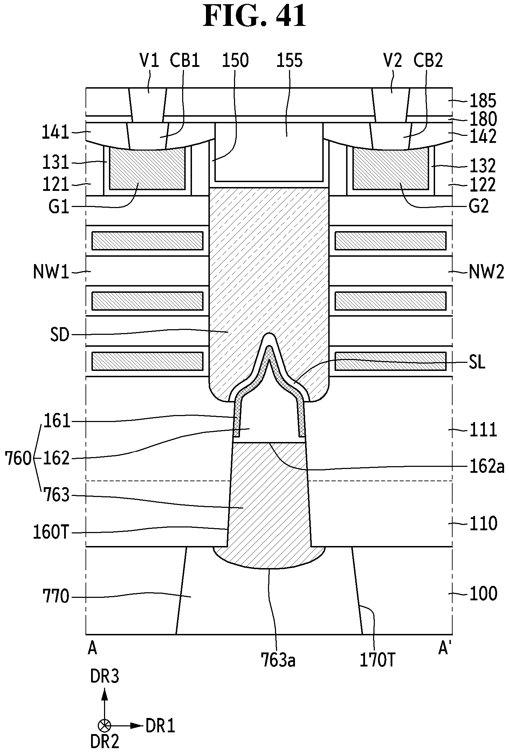

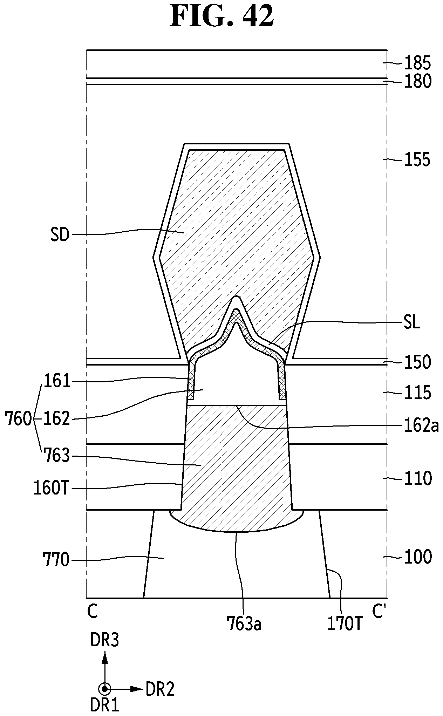

Hereinafter, a semiconductor device in accordance with some other example embodiments of the present disclosure will be described with reference to FIGS. 41 and 42. The description will focus on the differences from the semiconductor device shown in FIGS. 1 to 5.

FIGS. 41 and 42 are cross-sectional views for explaining a semiconductor device according to another example embodiments of the present disclosure.

Referring to FIGS. 41 and 42, in a semiconductor device according to yet some other example embodiments of the present disclosure, at least a portion of the second filling layer 763 may be in contact with the bottom surface of the first lower interlayer insulating layer 110.

For example, the source/drain contact 760 may include the barrier layer 161, the first filling layer 162, and the second filling layer 763. For example, in portions adjacent to both sidewalls of the contact trench 160T in the first horizontal direction DR1, at least a portion of the second filling layer 763 may be in contact with the bottom surface of the first lower interlayer insulating layer 110. Additionally, in portions adjacent to both sidewalls of the contact trench 160T in the second horizontal direction DR2, at least a portion of the second filling layer 763 may be in contact with the bottom surface of the first lower interlayer insulating layer 110. The bottom surface of the second filling layer 763 may be in contact with the bottom via 770. The lowermost surface 763a of the second filling layer 763 may be formed lower than the bottom surface of the first lower interlayer insulating layer 110.

While some example embodiments according to the present disclosure have been described above with reference to the accompanying drawings, it will be understood that the present disclosure is not limited to the above embodiments and may be fabricated in a variety of different forms, and those of ordinary skill in the art to which the present disclosure belongs, may recognize that inventive concepts may be implemented in other specific forms without changing the technical ideas or essential features of the present disclosure. Therefore, it should be understood that the above-described embodiments are non-limiting examples in all respects and not restrictive.
Embodiments are set out in the following clauses:
Clause 1. A semiconductor device comprising: a first lower interlayer insulating layer; an insulating pattern extending in a first horizontal direction on an upper surface of the first lower interlayer insulating layer; a plurality of nanosheets stacked and spaced apart from each other in a vertical direction on the insulating pattern; a gate electrode extending in a second horizontal direction on the insulating pattern, the gate electrode surrounding the plurality of nanosheets, the second horizontal direction being different from the first horizontal direction; a source/drain region on one side of the gate electrode and on the insulating pattern, the source/drain region, the first lower interlayer insulating layer, and the insulating pattern defining a contact trench penetrating the first lower interlayer insulating layer and the insulating pattern in the vertical direction, the contact trench extending into an inside of the source/drain region; and a source/drain contact filling an inside of the contact trench, the source/drain contact electrically connected to the source/drain region, wherein the source/drain contact includes a barrier layer along a portion of an upper sidewall and an upper surface of the contact trench, a first filling layer filling a space between parts of the barrier layer inside the contact trench, and a second filling layer filling the inside of the contact trench under a bottom surface of the first filling layer, a sidewall in the first horizontal direction of the barrier layer is in contact with the insulating pattern, the first filling layer is multi grain and has a first average grain size in the first horizontal direction, a sidewall in the first horizontal direction of the second filling layer is in contact with each of the first lower interlayer insulating layer and the insulating pattern, and the second filling layer is single grain.
Clause 2. The semiconductor device of clause 1, wherein an outer sidewall in the first horizontal direction of the barrier layer in contact with the insulating pattern is aligned with the sidewall in the first horizontal direction of the second filling layer in contact with the insulating pattern.
Clause 3. The semiconductor device of clause 1 or 2, further comprising: a second lower interlayer insulating layer on a bottom surface of the first lower interlayer insulating layer; and a bottom via in a via trench defined in the second lower interlayer insulating layer, the bottom via being in contact with a bottom surface of the second filling layer, the bottom via being multi grain and having a second average grain size in the first horizontal direction, wherein the second average grain size is at least 1.5 times greater than the first average grain size.
Clause 4. The semiconductor device of clause 3, wherein the first filling layer, the second filling layer and the bottom via include a same material.
Clause 5. The semiconductor device of clause 3 or 4, wherein a portion of the bottom via is inside the contact trench, and a sidewall in the first horizontal direction of the bottom via inside the contact trench is in contact with the first lower interlayer insulating layer.
Clause 6. The semiconductor device of any one preceding clause, wherein a lowermost surface of the barrier layer overlaps with an upper surface of the second filling layer in the vertical direction.
Clause 7. The semiconductor device of any one preceding clause, wherein an uppermost surface of the first filling layer is higher than a bottom surface of the source/drain region.
Clause 8. The semiconductor device of any one preceding clause, wherein a lowermost surface of the barrier layer is in contact with the first filling layer, and a sidewall in the first horizontal direction of the first filling layer on the lowermost surface of the barrier layer is in contact with the insulating pattern.
Clause 9. The semiconductor device of any one preceding clause, wherein a lowermost surface of the second filling layer is lower than a bottom surface of the first lower interlayer insulating layer.
Clause 10. The semiconductor device of anyone preceding clause wherein the source/drain contact further comprises a seam pattern inside the first filling layer, the seam pattern is spaced apart from the barrier layer, and the seam pattern is in contact with an upper surface of the second filling layer.
Clause 11. The semiconductor device of any one preceding clause, wherein the bottom surface of the first filling layer is convex toward the second filling layer.
Clause 12. The semiconductor device of any one preceding clause, further comprising: a silicide layer along an interface between the source/drain region and the barrier layer.
Clause 13. A semiconductor device comprising, a first lower interlayer insulating layer; an insulating pattern extending in a first horizontal direction on an upper surface of the first lower interlayer insulating layer; a gate electrode extending in a second horizontal direction different from the first horizontal direction on the insulating pattern; a source/drain region on one side of the gate electrode and on the insulating pattern, the source/drain region, the first lower interlayer insulating layer, and the insulating pattern defining a contact trench penetrating the first lower interlayer insulating layer and the insulating pattern in a vertical direction, the contact trench extending into an inside of the source/drain region; a source/drain contact filling an inside of the contact trench, the source/drain contact being electrically connected to the source/drain region; a second lower interlayer insulating layer on a bottom surface of the first lower interlayer insulating layer; and a bottom via in a via trench defined in the second lower interlayer insulating layer, the bottom via being in contact with a bottom surface of the source/drain contact, the bottom via multi grain, wherein the source/drain contact includes a barrier layer along a portion of an upper sidewall and an upper surface of the contact trench, a first filling layer filling a space between parts of the barrier layer inside the contact trench, and a second filling layer filling the inside of the contact trench under a bottom surface of the first filling layer, a sidewall in the first horizontal direction of the barrier layer being in contact with the insulating pattern, the first filling layer is multi grain and has a first average grain size in the first horizontal direction, a bottom surface of the second filling layer is in contact with the bottom via, a sidewall in the first horizontal direction of the second filling layer is in contact with each of the first lower interlayer insulating layer and the insulating pattern, the second filling layer is single grain, and a second average grain size of the bottom via in the first horizontal direction is at least 1.5 times greater than the first average grain size.
Clause 14. The semiconductor device of clause 13, wherein the bottom surface of the second filling layer is convex toward the bottom via.
Clause 15. The semiconductor device of clause 13 or 14, wherein at least a portion of the second filling layer is in contact with the bottom surface of the first lower interlayer insulating layer.

## Claims

1. A semiconductor device comprising:
a first lower interlayer insulating layer;
an insulating pattern extending in a first horizontal direction on an upper surface of the first lower interlayer insulating layer;
a gate electrode extending in a second horizontal direction on the insulating pattern, the second horizontal direction being different from the first horizontal direction;
a source/drain region on one side of the gate electrode and on the insulating pattern,
the source/drain region, the first lower interlayer insulating layer, and the insulating pattern defining a contact trench penetrating the first lower interlayer insulating layer and the insulating pattern in the vertical direction, the contact trench extending into an inside of the source/drain region; and
a source/drain contact filling an inside of the contact trench, the source/drain contact electrically connected to the source/drain region, wherein
the source/drain contact includes a barrier layer along a portion of an upper sidewall and an upper surface of the contact trench, a first filling layer filling a space between parts of the barrier layer inside the contact trench, and a second filling layer filling the inside of the contact trench under a bottom surface of the first filling layer,
a sidewall in the first horizontal direction of the barrier layer is in contact with the insulating pattern,
the first filling layer is multi grain and has a first average grain size in the first horizontal direction,
a sidewall in the first horizontal direction of the second filling layer is in contact with each of the first lower interlayer insulating layer and the insulating pattern, and
the second filling layer is single grain.

2. The semiconductor device of claim 1, wherein an outer sidewall in the first horizontal direction of the barrier layer in contact with the insulating pattern is aligned with the sidewall in the first horizontal direction of the second filling layer in contact with the insulating pattern.

3. The semiconductor device of claim 1 or 2, further comprising:
a second lower interlayer insulating layer on a bottom surface of the first lower interlayer insulating layer; and
a bottom via in a via trench defined in the second lower interlayer insulating layer, the bottom via being in contact with a bottom surface of the second filling layer, the bottom via being multi grain and having a second average grain size in the first horizontal direction,
optionally wherein the second average grain size is at least 1.5 times greater than the first average grain size.

4. The semiconductor device of claim 3, wherein the first filling layer, the second filling layer and the bottom via include a same material.

5. The semiconductor device of claim 3 or 4, wherein a portion of the bottom via is inside the contact trench, and a sidewall in the first horizontal direction of the bottom via inside the contact trench is in contact with the first lower interlayer insulating layer.

6. The semiconductor device of any one of claims 1 to 5, wherein a lowermost surface of the barrier layer overlaps with an upper surface of the second filling layer in the vertical direction.

7. The semiconductor device of any one of claims 1 to 6, wherein an uppermost surface of the first filling layer is higher than a bottom surface of the source/drain region.

8. The semiconductor device of any one of claims 1 to 7, wherein
a lowermost surface of the barrier layer is in contact with the first filling layer, and
a sidewall in the first horizontal direction of the first filling layer on the lowermost surface of the barrier layer is in contact with the insulating pattern.

9. The semiconductor device of any one of claims 1 to 8, wherein a lowermost surface of the second filling layer is lower than a bottom surface of the first lower interlayer insulating layer.

10. The semiconductor device of any one of claims 1 to 9 wherein
the source/drain contact further comprises a seam pattern inside the first filling layer,
the seam pattern is spaced apart from the barrier layer, and
the seam pattern is in contact with an upper surface of the second filling layer.

11. The semiconductor device of any one of claims 1 to 10, wherein the bottom surface of the first filling layer is convex toward the second filling layer.

12. The semiconductor device of any one of claims 1 to 11, further comprising:
a silicide layer along an interface between the source/drain region and the barrier layer.

13. The semiconductor device of any one of claims 1 to 12, wherein the bottom surface of the second filling layer is convex toward the bottom via.

14. The semiconductor device of any one of claims 1 to 13, wherein at least a portion of the second filling layer is in contact with the bottom surface of the first lower interlayer insulating layer.

15. The semiconductor device of any one of claims 1 to 14, including a plurality of nanosheets are stacked and spaced apart from each other in a vertical direction on the insulating pattern, wherein the gate electrode surrounds the plurality of nanosheets.
